# EUROPEAN PATENT APPLICATION

(11) **EP 4 572 592 A1**
(43) Date of publication of application: **18.06.2025**
(21) Application number: 23215635.6
(22) Date of filing: 11.12.2023
(51) Int. Cl.: H10N 70/20, H10N 70/00, H10N 79/00

(54) **DEVICE COMPRISING PHASE CHANGE SWITCH DEVICE AND METHOD FOR PROVIDING THE SAME**

(71) Applicant: Infineon Technologies AG, 85579 Neubiberg (DE)
(72) Inventor: KÄMMER, Kerstin, 01445 Radebeul (DE); MARKERT, Matthias, 01689 Weinböhla (DE); PFLAUM, Bernd, 82008 Unterhaching (DE)
(74) Representative: Kraus & Lederer PartGmbB

(57) **Abstract**

A device is provided, comprising a first portion (21A-21C) having a phase change switch device on a first substrate and a second portion (20) having a semiconductor circuit on a second substrate. The first and second portions are bonded together.

## Description

### TECHNICAL FIELD

The present application relates to devices including phase change switch devices and to corresponding methods.

### BACKGROUND

The technical requirements for radio frequency (RF) applications using high frequencies, such as radar sensing and mobile communication according to the 5G standard, are increasing. In particular, switches having improved characteristics compared to state-of-the-art CMOS switches will be required to meet future demands. Phase change switches are considered as promising candidates for switching RF signals. Such phase change switches use a phase change material (PCM) which typically exhibits a higher electric conductivity in a crystalline phase state than in an amorphous phase state. By changing the phase state of the phase change material, a switch device including such a material may be switched on and off.

For example, to change the phase state from amorphous to crystalline, typically a heater is employed heating the phase change material causing crystallization. This switching on by causing crystallization is also referred to as a set operation. In the set operation, the heater is actuated in such a way that the temperature of the phase change material is above its crystallization temperature, typically about 250°C, but below the melt temperature typically in a range of 600°C to 900°C, for example. The length of the heating pulse caused by the heater is chosen such that any amorphous portion present in the PCM can regrow into the crystalline phase state.

When switching off the switching device, also referred to as reset operation, the heater is actuated in such a way that the temperature of the PCM is raised above the melt temperature (for example above about 600°C to 900°C) followed by a comparatively rapid cooldown which freezes the phase change material or at least a portion thereof into an amorphous state.

Suitable phase change materials used for such phase change switches include germanium telluride (GeTe) or germanium-antimony-tellurium (GeSbTe, usually referred to as GST), and heaters may be made of a material like polycrystalline silicon or tungsten.

PCM switch devices promise excellent radio frequency performance in comparison to state of the art CMOS RF switches. In particular, the main figure of merit, the product of on-resistance and off capacitance, is reduced significantly from around 80 fsec for CMOS RF switches to values below 20fsec for PCM switch devices.

The control logic for controlling such PCM switch devices is often implemented in CMOS technology. Integrating the phase change switch device itself with such a logic presents a challenge, as the processing steps required for providing and structuring the phase change material and other components of the PCM switch device are, as a rule, not included in a standard CMOS processing workflow, and the processing may have to compromise between requirements for the phase change switch device and requirements for the CMOS circuit.

### SUMMARY

According to an embodiment, a device is provided, comprising:
- a first portion comprising a phase change switch device provided on a first substrate, the phase change switch device comprising a phase change material and a heater thermally coupled to the phase change material, and
- a second portion comprising a semiconductor circuit provided on a second substrate different from the first substrate,
wherein the first portion is bonded to the second portion.

According to another embodiment, a method is provided, comprising:
providing a first portion comprising a phase change switch device provided on a first substrate, the phase change switch device comprising a phase change material and a heater thermally coupled to the phase change material, and
providing a second portion comprising a semiconductor circuit provided on a second substrate different from the first substrate, and
bonding the first portion to the second portion.

### BRIEF DESCRIPTION OF THE DRAWINGS

Fig. 1 is a schematic view of a phase change switch device usable in some embodiments.
Fig. 2 is a side view of a device according to an embodiment.
Figs. 3A and 3B are cross-sectional views of a phase change switch device portion of a device according to an embodiment.
Fig. 4 is a cross-sectional view of a device according to an embodiment.
Fig. 5 shows a flowchart illustrating a method according to an embodiment.

### DETAILED DESCRIPTION

In the following, various embodiments will be described in detail referring to the attached drawings. The embodiments described hereinafter are to be taken as examples only and are not to be construed as limiting. For example, while in embodiments specific arrangements or components are provided, in other embodiments other configurations may be used.

Implementation details described with respect to one of the embodiments are also applicable to other embodiments.

Features from different embodiments may be combined to form further embodiments. Variations and modifications described for one of the embodiments may also be applied to other embodiments and will therefore not be described repeatedly.

In the Figures, like elements are designated with the same reference numerals. Such elements will not be described repeatedly in each Figure to avoid repetitions. Any directional terminology used when referring to the drawings (e.g. up, down, left, right) is merely for indicating elements and directions in the drawings and is not intended to imply a directional orientation of the actually implemented devices.

Besides features (for example components, elements, acts, events or the like) explicitly shown and described, in other embodiments additional features may be provided, for example features used in conventional switch devices using phase change materials. For example, embodiments described herein relate to providing a phase change switch device and a semiconductor circuit on two different substrates and then bonding the two portions such formed together. Manufacturing of the phase change switch device and the semiconductor circuit itself may use conventional techniques, like providing phase change material on a substrate like a silicon substrate or glass substrate to implement a phase change switch device or in a part thereof like a trench for manufacturing the switch device , or manufacturing the semiconductor circuit using a standard CMOS process.

A switch based on a phase change material (PCM) will be referred to as a phase change switch (PCS) or PCM switch herein. As explained in the introductory portion, such phase change switches may be set to a crystalline phase state or an amorphous phase change, thus changing the resistance of the phase change material and therefore of the switch by several orders of magnitude. In this way, for example an on-resistance of a switch in a range of 1 to 100 Ω may be achieved, whereas an off-resistance may be several orders of magnitude higher, for example at least in the Kiloohm range.

PCM switch devices discussed herein may be manufactured for example in layer deposition and pattering processes similar to those used in semiconductor device manufacturing, by depositing or modifying layers on a substrate. In some embodiments discussed herein, cross-sectional views and top views are illustrated. A cross-sectional view essentially corresponds to a cross section through the substrate, whereas a top view is a view in a direction towards a surface of the substrate.

While phase change switch devices in the embodiment below are shown with a configuration where a heater is provided below a phase change material, in other embodiments the heater may be provided above the phase change material. Furthermore, currents through the phase change material and through the heater may run in the same direction or in different, for example perpendicular directions. Therefore, the specific configurations shown are not to be construed as limiting in any way.

In contrast to conventional devices, in devices discussed herein a phase change switch device is provided on a first substrate to provide a first portion of the device, and semiconductor devices are provided on a second substrate to perform a second portion of the device, and the first and second portions are then bonded together. In this way, for example regarding choice of substrate, processing technology and the like, manufacturing of the first portion may be optimized for the phase change switch device, for example in terms of parasitic capacitances, and for the second portion standard processes like standard CMOS processes without the need for modifications to accommodate for the deposition of a phase change material and the like may be used.

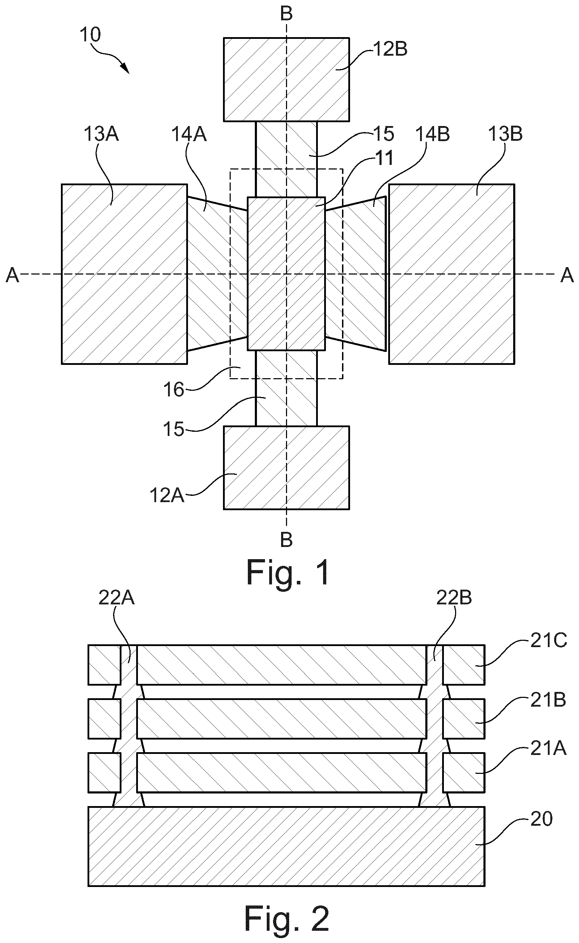

Turning now to the Figures, Fig. 1 is a schematic top view of a phase change switch device 10 usable in some embodiments. Phase change switch device 10 includes a phase change material (PCM) 11 coupled to electrodes 13A, 13B via conductive materials 14A, 14B. As will be explained further below in more detail electrodes 13A, 13B may provide contact pads made for example of aluminum or copper, and conductive material 14A, 14B may for example be tungsten.

Furthermore, phase change switch 10 comprises a heater 15 which in the top view of Fig. 1 is arranged below phase change material 11. Heater 15 is contacted by electrodes 12A, 12 B, which, similar to electrodes 13A and 13B, may provide contact pads made for example of aluminum or copper, as will be explained further below. Heater 15 may be a resistive heater, for example made of tungsten. In other embodiments, heater 15 may be a heater formed by a semiconductor device, for example a PIN diode or a transistor. Irrespective of the type of heater, to heat phase change material 11 current is provided through heater 15 via terminals 12A, 12B, which causes power dissipation and hence heating in heater 15 and therefore heats phase change material 11.

In some embodiments which will be discussed in more detail below, phase change material 11 may be arranged within a cavity 16. This cavity may protect phase change material 11.

Phase change switch device 10 in embodiments discussed herein is formed on a first substrate, for example a semiconductor wafer like a silicon wafer or also another substrate like for example a glass substrate. This first substrate is used only for forming a phase change switch device including one or more phase change switches. In this respect, while in the embodiments discussed herein a single phase change switch may be used, in other embodiments a plurality of phase change switches may be provided.

In this way, the process may be optimized for phase change switch 10, for example to reduce parasitic capacitances, in particular off-capacitances (i.e. capacitances when the phase change switch device is switched off). "Forming on the substrate" also includes the possibility that part of the device is formed in the substrate. For example, if the substrate is a silicon substrate, a PIN diode to serve as a heater may be formed by ion implantation in the substrate, or by providing corresponding doped layers on the substrate.

This first portion including the phase change switch device 10 may then be bonded to a second portion including semiconductor circuit. A schematic corresponding embodiment of a device is shown in Fig. 2.

In the embodiment of Fig. 2, a plurality of first portions 21A-21C are provided, each including one or more phase change switches, for example phase change switches as described in Fig. 1, on respective first substrates. Furthermore, a second portion 20 is provided comprising a semiconductor circuit provided on a second substrate. Also here, "provided on" also includes "in", i.e. including for example doped regions formed in the substrate to form the semiconductor circuit.

The second substrate may be a semiconductor substrate like a silicon substrate.

The semiconductor circuit in second portion 20 may for example include circuitry to control the phase change switches in first portions 21A-21C, like drivers for heater 15 of phase change switch device 10, or may include radio frequency circuitry providing signals to be switched by the phase change switches. In other embodiments, drivers for heater 15 or at least high voltage portions thereof may be included in the respective first portions (i.e. formed in the first substrate), and only RF circuitry is provided in the second portion 20. First portions 21A-21C are bonded to second portion 20 and electrically connected by interconnects 22A, 22B. While three first portions 21A-21C are shown in Fig. 2, in other embodiments only a single first portion or any other number of first portions may be provided. Likewise, while two interconnects 22A, 22B are shown, in other embodiments any other number of interconnects, depending on the number of electrical connections necessary, may be used.

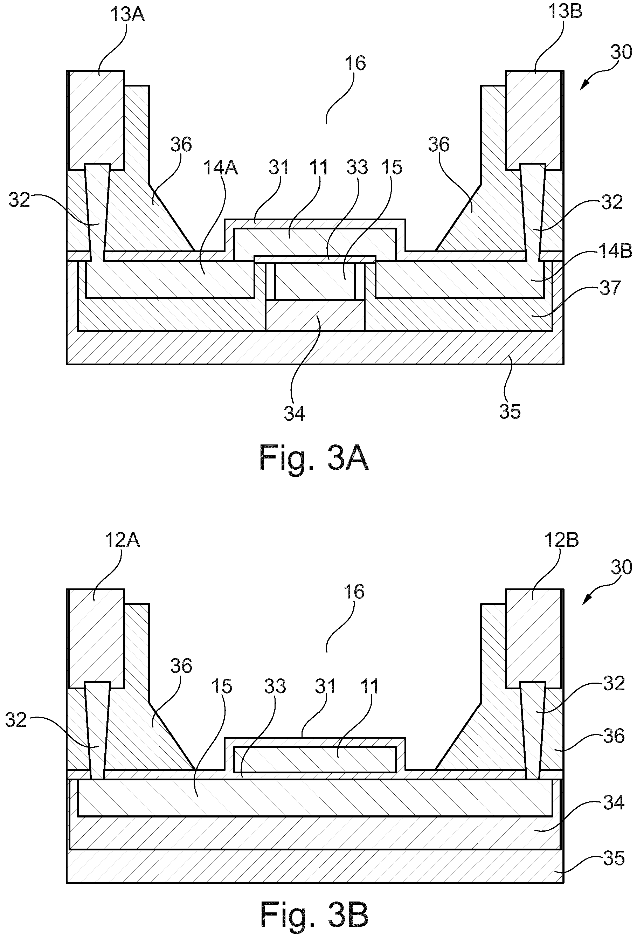

Next, specific implementations of a first portion will be discussed referring to Figs. 3A and 3B. Fig. 3A corresponds to a cross-section along a line A-A in Fig. 1, and Fig. 3B corresponds to a cross-section along a line B-B in Fig. 1.

Elements that have already been described with reference to Fig. 1 bear the same reference numerals in Figs. 3A and 3B and will not be described again in detail.

In Fig. 3B, the phase change switch device 10 of Fig. 1 is formed on a substrate 35, which as mentioned above may be a semiconductor substrate in some embodiments. In case heater 15 is a semiconductor device like PIN diode or another semiconductor device, it may be formed in an isolation well 34 in substrate 35. In embodiments where the heater is for example a simple resistive heater made for example of tungsten, isolation well 34 may be omitted, and substrate 35 need not be a semiconductor substrate, but may e.g. also be a glass substrate. Isolation well 34 may be any semiconductor isolation well conventionally used, for example doped with a polarity different than a polarity of doping of substrate 35, or may include multiple doped layers, for example in a triple well configuration.

A thermally conducting, but electrically insulating layer 33 separates heater 15 from phase change material 11. A cap layer 31 is provided above phase change material 11. Layers 31, 33 may be dielectric layers, for example made of silicon oxide or silicon nitride.

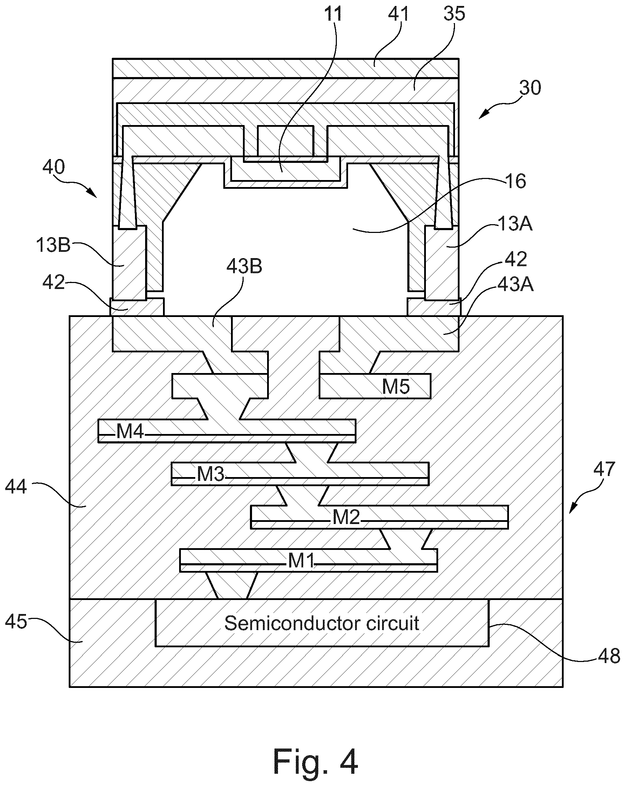

Conducting materials 14A, 14B explained with reference to Fig. 1 are provided in substrate 35 in shallow trench isolations (STI) 37 in the embodiment of Figs. 3A and 3B. Furthermore, a cavity 16 is formed for example by etching or other processing of an interlayer dielectric 36, for example silicon oxide, accordingly. A depth of cavity 16 in a direction perpendicular to the interface between first portion 30 and the second portion (see Fig. 4) after bonding may be less than 10µm. Terminals 13A, 13B are electrically coupled to conductive materials 14A, 14B and therefore to phase change material 11 via contact vias (vertical interconnect access) 32, and likewise terminals 12A, 12B are coupled to heater 15 through contact vias 32. As mentioned, terminals 12A, 12B, 13A, 13B may be made for example of aluminum or copper.

It should be noted that the configuration shown in Figs. 3A and 3B is merely an example, and several variations are possible. For instance, while heater 15 is arranged below phase change material 11 in the embodiment shown, in other embodiments heater 15 may be provided above phase change material 11. Furthermore, while the current paths for the phase change material 11 (shown in Fig. 3A, between terminals 13A and 13B) and for heater 15(shown in Fig. 3B between terminals 12A and 12B) are perpendicular in each other, in other embodiments parallel current paths may be used. Therefore, the configuration shown is merely as an example.

Fig. 4 illustrates a device 40 according to an embodiment using the first portion 30 discussed with reference to Figs. 3A and 3B. First portion 30 is bonded to a second portion 47. Second portion 47 includes a second substrate 45, in this case a semiconductor substrate, with a semiconductor circuit 48 formed on the wafer. For example, second substrate may be a CMOS wafer, i.e. a silicon wafer processed according to a CMOS process, to form semiconductor circuit 48 therein, for example logic circuits, driver circuits or the like. Above substrate 45, a back end of line (BEOL) layer stack 44 is formed, including metal layers M1-M5 and dielectric layers therebetween. BEOL stack 44 may also be formed in a CMOS process. While five metal layers M1-M5 are shown, this is merely an example, and a different number of metal layers may also be used. Metal layers M1-M5 are coupled by vertical interconnects.

The configuration of the metal layers and their interconnects is merely an example, and connections may be made as needed for connecting parts of the semiconductor circuit formed in substrate 45 with each other and to connect the semiconductor circuit to first portion 30. Furthermore, it is to be noted that Fig. 4 shows a cross-section only, such that e.g. metal layer M5 is not isolated from the semiconductor circuits, but merely the connection is not visible in the cross-section shown.

At top of BEOL stack 45, 44, contact pads 43A, 43B are provided. These contact pads are bonded to terminals 13A, 13B. Further contact pads (not shown in the cross-sectional view of Fig. 4) are provided for bonding to terminals 12A, 12B to also electrically contact the heater. In this way, parts of the semiconductor circuit 48 using the phase change switch for switching may be coupled to terminals 13A, 13B and a driver used for heating may be coupled to terminals 12A, 12B. As mentioned above, in other embodiments at least high voltage portions of such a driver may be included in the first portion, e.g. formed in substrate 35.

For bonding, various techniques may be used, depending on the material of terminals 13A, 13B, and contact pads 43A, 43B. For example, if terminals 13A, 13B are aluminum terminals and contact pads 43A, 43B are aluminum contact pads, aluminum-germanium (Al-Ge) eutectic bonding as indicated by reference numeral 42 may be used. In case terminal 13A, 13B and contact pads 43A, 43B are made of copper, a direct copper-copper (Cu-Cu) interconnect bonding may be used.

As can be seen, with the bonding phase change material 11 is protected in cavity 16. For example, cavity 16 offers protection against packaging processes. Furthermore, cavity 16 decouples phase change material 11 and the phase change switch in general from BEOL stack 44 both thermally and mechanically. To adjust the thermal coupling, a gas may be filled in cavity 16, or a vacuum may be provided. While the cavity is formed in the first portion in the embodiment shown, in other embodiments the cavity also may be formed in second portion 47, i.e. in BEOL stack 44, which implies that the metal connections by the metal layers and vertical interconnects have to be routed around the cavity, or in both first portion 30 and second portion 47. For bonding first portion 30 to second portion 47, a sealing ring may be formed around cavity 16, which in the cross-section of Fig. 4 may be adjacent to element 42, but completely surround cavity 16 at the interface between first portion 30 and second portion 47.

To improve thermal dissipation and/or to reduce parasitic capacitances, first substrate 35 may be thinned and provided with a heat spreader layer 41.

Furthermore, through the vertical interconnects short signal paths between the phase change switch device and the semiconductor circuit 48 may be achieved (in this respect, the drawing is not to scale), which may reduce the effective on-resistance of the phase change switch.

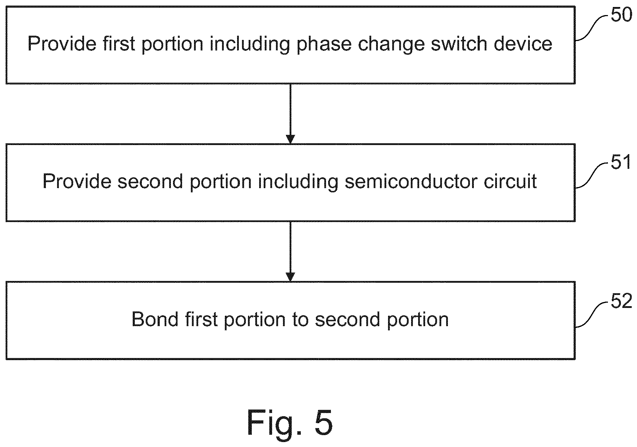

Fig. 5 illustrates a method of manufacturing a device according to some embodiments. The method of Fig. 5 may be used to manufacture the devices discussed previously and will be described referring to the previous discussion to avoid repetitions.

At 50, the method comprises providing a first portion including a phase change switch device, for example first portions 21A-21C or 30 discussed above.

At 51, the method comprises providing a second portion including a semiconductor circuit, for example second portion 47 of Fig. 4. It should be noted that the providing at 50 and the providing at 51 may be performed in any order or also in parallel by different processing lines.

At 52, the method comprises bonding the first portion to the second portion, for example as described with reference to Fig. 4 by AlGe eutectic bonding or by Cu-Cu interconnect bonding.

Some embodiments are defined by the following examples:
Example 1. A device, comprising:
   - a first portion comprising a phase change switch device provided on a first substrate, the phase change switch device comprising a phase change material and a heater thermally coupled to the phase change material, and
   - a second portion comprising a semiconductor circuit provided on a second substrate different from the first substrate,
      wherein the first portion is bonded to the second portion.
Example 2. The device of example 1,
   wherein the first portion comprises one or more first contact portions, each first contact portion being electrically coupled either to the phase change material or to the heater, wherein the second portion comprises one or more second contact portions being electrically coupled to the semiconductor circuit,
   wherein the first contact portions are electrically coupled to the second contact portions through the bonding.
Example 3. The device of example 2, wherein the second contact portions are coupled to the semiconductor circuit via one or more structured metal layers )M1 - M5) formed on the second substrate.
Example 4. The device of example 2 or 3, wherein at least one of the first contact portions and second contact portions is made of a material selected from the group consisting of aluminum and copper.
Example 5. The device of any one of examples 1 to 4, wherein the second substrate is a silicon substrate.
Example 6. The device of example 5, wherein the semiconductor circuit is a CMOS circuit.
Example 7. The device of any one of examples 1 to 6, wherein the first substrate comprises one of a semiconductor substrate or a glass substrate.
Example 8. The device of any one of examples 1 to 7, wherein the semiconductor circuit comprises at least one of:
   - a driver circuit configured to drive the heater of the phase change switch device,
   - a control circuit controlling switching of the phase change switch device, or
   - a radio frequency circuit coupled to the phase change switch device.
Example 9. The device of any one of examples 1 to 8, wherein at least a portion of a drive circuit configured to drive the heater of the phase change switch device is provided on the first substrate.
Example 10. The device of any one of examples 1 to 9, wherein at least one of the first portion or the second portion comprises a cavity, wherein the phase change material is provided in the cavity of example 10, further comprising a sealing ring around the cavity.
Example 11. The device of example 10, further comprising a sealing ring around the cavity.
Example 12. The device of example 10 or 11, wherein a depth of the cavity in a direction perpendicular to an interface between the first portion and second portion is less than 10 um.
Example 13. The device of any one of examples 1 to 12, wherein the heater is selected from the group consisting of a resistive heater and a heater based on a pin diode.
Example 14. A method, comprising:
   providing a first portion comprising a phase change switch device provided on a first substrate, the phase change switch device comprising a phase change material and a heater thermally coupled to the phase change material, and
   providing a second portion comprising a semiconductor circuit provided on a second substrate different from the first substrate, and
   bonding the first portion to the second portion.
Example 15. The method of example 14, wherein the method is adapted to manufacture the device of any one of examples 1 to 13.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A device (40), comprising:
- a first portion (21A-C, 30) comprising a phase change switch device (10) provided on a first substrate (35), the phase change switch device (10) comprising a phase change material (11) and a heater (15) thermally coupled to the phase change material (11), and
- a second portion (20, 47) comprising a semiconductor circuit (48) provided on a second substrate (45) different from the first substrate (35),
wherein the first portion (21A-C, 30) is bonded to the second portion (20, 47).

2. The device of claim 1,
wherein the first portion (21A-C, 30) comprises one or more first contact portions (12A, 12B, 13A, 13B), each first contact portion (12A, 12B, 13A, 13B) being electrically coupled either to the phase change material (11) or to the heater (15),
wherein the second portion (20, 47) comprises one or more second contact portions (43A, 43B) being electrically coupled to the semiconductor circuit,
wherein the first contact portions (12A, 12B, 13A, 13B) are electrically coupled to the second contact portions (43A, 43B) through the bonding.

3. The device (40) of claim 2, wherein the second contact portions (43A, 43B) are coupled to the semiconductor circuit via one or more structured metal layers )M1 - M5) formed on the second substrate (45).

4. The device (40) of claim 2 or 3, wherein at least one of the first contact portions (12A, 12B, 13A, 13B) and second contact portions (43A, 43B) is made of a material selected from the group consisting of aluminum and copper.

5. The device (40) of any one of claims 1 to 4, wherein the second substrate (45) is a silicon substrate.

6. The device (40) of claim 5, wherein the semiconductor circuit (48) is a CMOS circuit.

7. The device (40) of any one of claims 1 to 6, wherein the first substrate (35) comprises one of a semiconductor substrate or a glass substrate.

8. The device (40) of any one of claims 1 to 7, wherein the semiconductor circuit (48) comprises at least one of:
- a driver circuit configured to drive the heater (15) of the phase change switch device (10),
- a control circuit controlling switching of the phase change switch device (10), or
- a radio frequency circuit coupled to the phase change switch device (10).

9. The device (40) of any one of claims 1 to 8, wherein at least a portion of a drive circuit configured to drive the heater (15) of the phase change switch device (10) is provided on the first substrate.

10. The device (40) of any one of claims 1 to 9, wherein at least one of the first portion (21A-C, 30) or the second portion (20, 47) comprises a cavity (16), wherein the phase change material (11) is provided in the cavity (16=.

11. The device (40) of claim 10, further comprising a sealing ring around the cavity (16).

12. The device (40) of claim 10 or 11, wherein a depth of the cavity (16) in a direction perpendicular to an interface between the first portion (21A-C, 30) and second portion (20, 47) is less than 10 pm.

13. The device of any one of claims 1 to 12, wherein the heater (15) is selected from the group consisting of a resistive heater and a heater based on a pin diode.

14. A method, comprising:
providing a first portion (21A-C, 30) comprising a phase change switch device provided on a first substrate, the phase change switch device comprising a phase change material and a heater thermally coupled to the phase change material, and
providing a second portion (20, 47) comprising a semiconductor circuit provided on a second substrate different from the first substrate, and
bonding the first portion (21A-C, 30) to the second portion (20, 47).

15. The method of claim 14, wherein the method is adapted to manufacture the device of any one of claims 1 to 13.
